# FASCICULE DE BREVET EUROPEEN

(11) **EP 0 296 030 B1**
(45) Date de publication et mention de la délivrance du brevet: **20.10.1993**
(21) Numéro de dépôt: 88401407.7
(22) Date de dépôt: 09.06.1988
(51) Int. Cl.: H01L 29/60, H01L 29/78, H01L 21/28

(54) **Cellule de mémoire non volatile et son procédé de fabrication**
Nichtflüchtige Speicherzelle und Verfahren zu ihrer Herstellung
Non volatile memory cell and process for making the same

(30) Priorité: 12.06.1987 FR 8708214
(43) Date de publication de la demande: 21.12.1988
(73) Titulaire: COMMISSARIAT A L'ENERGIE ATOMIQUE, 75015 Paris Cédex 15 (FR)
(72) Inventeur: Jeuch, Pierre, F-38180 Seyssins (FR)
(74) Mandataire: Mongrédien, André

(56) Documents cités:
- EP-A- 0 067 475
- EP-A- 0 083 088
- EP-A- 0 193 841
- ELECTRONIC DESIGN, vol. 30, no. 4, 18 février 1982, pages 71-78, Waseca, Denville, US; D. BURSKY: "Fabrication gains feed the growth of digital VLSI"

## Description

La présente invention a pour objet une cellule de mémoire non volatile intégrée à grille flottante, ainsi que son procédé de fabrication. Plus spécialement, l'invention se rapporte aux cellules de mémoire EPROM (mémoire à lecture seulement, programmable électriquement) et EEPROM (EPROM effaçable électriquement) du type flash. Elle s'applique en particulier dans le domaine de la fabrication de circuits mémoires intégrés du type MOS ou CMOS.

Une mémoire EPROM ou E₂PROM intégrée est un circuit intégré comprenant une partie mémoire proprement dite, appelée cellule mémoire, formée de plusieurs points mémoires connectés électriquement entre eux, et des circuits périphériques servant à commander les points mémoires.

L'invention a trait uniquement à la partie mémoire proprement dite et à sa fabrication.

Les cellules mémoires EPROM à grille flottante les plus modernes, permettant la mémorisation de 10⁶ éléments binaires, présentent aujourd'hui des surfaces de 20 à 25 µm² dans une technologie de 1,2 µm, c'est-à-dire dans laquellle les bandes et les espaces les plus petits mesurent 1,2 µm. La surface d'une mémoire est donc d'environ 14 à 17 fois celle du carré élémentaire de la lithographie (1200 x 1200 nm²).

De plus en plus, on cherche à diminuer les dimensions des circuits intégrés, et en particulier des mémoires EPROM, en vue d'augmenter leur densité d'intégration. Malheureusement, dans les mémoires EPROM actuellement connues, deux facteurs limitent considérablement la réduction des dimensions de la cellule mémoire.

Le premier facteur est le débordement de la grille flottante au-dessus des isolations latérales ou oxyde de champ ; ce débordement est nécessaire du fait de l'imprécision de superpositions des différentes couches constituant les points mémoires et des masques de lithographie nécessaires pour la gravure des différentes couches.

Le second facteur est la nécessité de prévoir autour des trous de contact des lignes d'éléments binaires, c'est-à-dire autour des trous de contact des drains des points mémoires, et des trous de contact des lignes d'alimentation, c'est-à-dire des trous de contact des sources des points mémoires, des gardes isolantes.

La diminution des dimensions lithographiques, ne s'accompagnant généralement pas d'une amélioration proportionnelle dans les précisions de superposition des différents niveaux de masquage lithographique notamment, les facteurs de limitation ci-dessus vont être de plus en plus pénalisants pour l'augmentation de la densité d'intégration des mémoires EPROM.

Des procédés d'auto-alignement ou d'auto-positionnement évitant le débordement de la grille flottante sur l'oxyde de champ et/ou les gardes isolantes autour des trous de contact deviennent donc nécessaires pour la génération future des mémoires EPROM.

En plus des problèmes de densité d'intégration, les mémoires EPROM actuellement connues nécessitent, lors de la programmation, correspondant à l'écriture, l'application de tensions élevées sur la grille de commande des points mémoires, de l'ordre de 12 volts, afin d'injecter les électrons chauds, engendrés près du drain, dans la grille flottante. L'utilisation de tensions de programmation aussi élevées est assez contraignante pour la conception des circuits périphériques servant à commander la cellule mémoire.

Tous ces inconvénients existent aussi dans les mémoires EEPROM qui ne constituent que des EPROM particulières. Ceci ressort clairement de l'article IEDM 86 de S.K. Lai et al "Comparison and trends in today's dominant E² technologies",p.580-583 et de l'article IEDM 85 de S. Mukherjee et al "A single transistor EEPROM all and its implementation in a 512K CMOS EEPROM", p. 616-619.

On connait par ailleurs du document Electronic Design, vol. 30, n°4, février 1982, p. 71-78, une cellule mémoire non volatile comportant pour chaque point mémoire une grille flottante logée entièrement dans l'isolant inter-grille, lui-même logé entièrement dans la grille commande.

Dans le document EP-A-193 841, on enseigne une cellule de mémoire à grilles flottantes et à grilles de commande disposées dans un même plan.

La présente invention a justement pour objet une cellule mémoire non volatile, telle qu'une cellule EPROM ou EEPROM du type flash à grilles empilées, et son procédé de fabrication permettant de remédier aux différents inconvénients cités ci-dessus. En particulier, la cellule mémoire de l'invention présente un auto-positionnement intégral de tous les éléments constitutifs de ses points mémoires, conduisant à une surface de mémoire ne représentant que 4 à 5 fois la surface lithographique minimale. En outre, la cellule mémoire de l'invention n'est pas limitée à une technologie micronique et peut être réalisée selon une technologie submicronique.

Par ailleurs, elle présente des performances électriques améliorées. En effet, le temps d'accès de la cellule, lors de la programmation, est réduit et la tension d'écriture est diminuée ; on peut notamment envisager d'utiliser la même tension pour l'écriture et la lecture, tension de l'ordre de 5 volts.

De façon plus précise, l'invention a pour objet une cellule mémoire non volatile intégrée sur un substrat semiconducteur comportant (a) une matrice de points mémoires isolés électriquement et latéralement les uns des autres, chaque point mémoire comprenant un empilement de grilles formé d'un premier isolant en contact avec le substrat, d'une grille flottante et d'une grille de commande séparées l'une de l'autre par un second isolant, la grille flottante comportant une face en contact avec le premier isolant, une source et un drain formés dans le substrat de part et d'autre de l'empilement de grilles, et un canal situé dans le substrat sous ledit empilement, dont la longueur est orientée selon une première direction allant de la source au drain, et (b) des lignes conductrices servant à appliquer des signaux électriques sur les empilements de grilles et sur les drains, caractérisée en ce que le second isolant présente, dans un plan perpendiculaire à la surface du substrat et contenant la première direction, la forme d'un U renversé à l'intérieur duquel est logée entièrement la grille flottante et en ce que la grille de commande présente aussi la forme d'un U renversé ne comportant pas de prolongement selon la première direction, à l'intérieur duquel est logé entièrement le second isolant, la grille de commande ne débordant pas sur les isolations latérales aussi bien selon la première direction que selon une seconde direction perpendiculaire à la première.

La forme particulière de la grille flottante et de la grille de commande des points mémoires permet d'augmenter la surface de couplage entre ces deux grilles, jusqu'à au moins 4 fois la surface de la grille flottante, améliorant ainsi les performances électriques de la cellule mémoire.

De façon avantageuse, la grille flottante présente une hauteur au moins 2 fois plus grande que sa largeur, allant dans le sens de l'augmentation du couplage des grilles.

De préférence, la largeur de la grille flottante est inférieure à 0,5 µm, ce qui contribue fortement à la réduction des dimensions de la cellule mémoire.

Afin d'améliorer encore les performances électriques de la cellule, en diminuant la tension nécessaire à l'écriture dans un point mémoire, on utilise de préférence un premier matériau isolant présentant une épaisseur inférieure à celle du second isolant. En effet, l'injection des électrons chauds dans la grille flottante est d'autant plus efficace que l'isolant de grille de la grille flottante est mince.

En outre, la dégradation des points mémoires par les électrons chauds injectés du côté du drain dans la grille flottante des points mémoires est réduite grâce à un isolant inter-grille plus important. Dans le cas d'une grille flottante ayant une largeur inférieure à 0,5 µm et donc de points mémoires ayant des canaux inférieurs à 0,5 µm, on peut envisager de réaliser une structure de drain faiblement dopée en vue de réduire les effets de cette dégradation.

De façon avantageuse, les lignes conductrices servant à commander les empilements de grilles, correspondant aux lignes de mots, sont constituées de bandes parallèles à la direction des canaux des points mémoires et les lignes conductrices servant à commander les drains, correspondant aux lignes des éléments binaires, sont perpendiculaires à la direction des canaux des points mémoires. Ceci permet d'éviter l'emploi d'une couche isolante dans laquelle sont définis les trous de contact électrique pour les sources et les drains des points mémoires et par conséquent de gardes isolantes autour de ces trous de contact, réduisant ainsi de façon considérable les dimensions de la cellule mémoire.

De préférence, les lignes de commande des drains et celles d'alimentation des sources sont réalisées en métal tel que Al, W, Mo, Ta, ou bien en un siliciure d'un métal réfractaire tel que TiSi₂, TaSi₂, MoSi₂, WSi₂, PtSi.

Lorsque ces lignes d'éléments binaires et/ou d'alimentation sont réalisées en métal, une couche de barrière anti-diffusion doit être prévue entre les lignes conductrices de commande et le substrat semiconducteur, afin d'éviter la diffusion du métal de ces lignes conductrices dans le substrat. Cette couche anti-diffusion peut être réalisée en TiN, TiW.

De façon avantageuse, les lignes conductrices servant à commander les empilements de grilles sont réalisées en métal et en particulier en aluminium ou en tungstène.

L'invention a aussi pour objet un procédé de fabrication d'une cellule mémoire non volatile intégrée sur un substrat semiconducteur comportant (a) une matrice de points mémoires isolés électriquement les uns des autres par des isolations latérales, chaque point mémoire comprenant une grille flottante et une grille de commande empilées, isolées l'une de l'autre, une source et un drain situés de part et d'autre de l'empilement de grilles et un canal situé sous ledit empilement, dont la longueur est orientée selon une première direction allant de la source au drain, et (b) des lignes conductrices servant à appliquer des signaux électriques sur les empilements de grilles et sur les drains des points mémoires, caractérisé en ce que les grilles flottantes sont réalisées en déposant de façon isotrope sur des marches en un premier matériau une couche d'un second matériau conducteur que l'on peut graver sélectivement par rapport au premier matériau, en gravant la couche de second matériau de façon anisotrope jusqu'à mise à nu des marches, en formant les drains des points mémoires, en éliminant les marches de premier matériau et en ce qu'on réalise ensuite les grilles de commande isolées des grilles flottantes, les sources des points mémoires puis les lignes conductrices.

La réalisation de la grille flottante conformément à l'invention permet de réaliser avec une grande précision une grille flottante ayant une largeur submicronique et en particulier inférieure à 0,5 µm ainsi qu'une grille flottante ayant une hauteur nettement supérieure à sa largeur. Dans l'art antérieur, la hauteur de la grille flottante est généralement bien inférieure à sa largeur.

De façon avantageuse, on forme les empilements de grilles en effectuant les étapes successives suivantes :
(a) réalisation des marches de premier matériau sur un substrat semiconducteur d'un premier type de conductivité, ces marches ayant la forme de premières bandes orientées perpendiculairement à la première direction,
(b) dépôt d'un troisième matériau isolant sur le substrat, entre les marches,
(c) dépôt isotrope, sur les marches et le troisième matériau, de la couche de second matériau,
(d) gravure anisotrope de la couche de second matériau afin d'obtenir des secondes bandes conductrices parallèles aux premières bandes,
(e) élimination des marches et des régions du troisième matériau non recouvertes de second matériau,
(f) dépôt d'un quatrième matériau isolant sur les régions du substrat mises à nu lors de l'étape (e) et sur les secondes bandes conductrices,
(g) dépôt d'un cinquième matériau conducteur sur le quatrième matériau présentant des parties en surplomb en regard des secondes bandes conductrices,
(h) masquage à l'aide d'un sixième matériau des parties de cinquième matériau en surplomb,
(i) élimination des régions de cinquième et de quatrième matériaux non recouvertes de sixième matériau,
(j) réalisation d'un masque de lithographie présentant la forme de troisièmes bandes orientées perpendiculairement aux secondes bandes et définissant la longueur des empilements,
(k) élimination des régions de cinquième, quatrième, second et troisième matériaux non masquées, réalisant ainsi les empilements de grilles, et
(l) élimination du masque.

Le fait que la grille de commande recouvre la grille flottante sur trois côtés permet d'assurer un couplage maximum entre ces deux grilles.

Conformément à l'invention, le procédé de fabrication d'une cellule mémoire non volatile à double grille comprend les étapes successives suivantes :
(a') réalisation des marches de premier matériau sur le substrat semiconducteur,
(b') dépôt du troisième matériau isolant sur le substrat, entre les marches,
(c') dépôt isotrope sur les marches et le troisième matériau de la couche de second matériau,
(d') gravure anisotrope de la couche de second matériau afin d'obtenir les secondes bandes conductrices, puis implantations d'ions d'un second type de conductivité entre ces secondes bandes pour former en partie les drains,
(e') élimination des marches et des régions du troisième matériau non recouvertes de second matériau,
(f') dépôt du quatrième matériau,
(g') dépôt du cinquième matériau conducteur sur le quatrième matériau,
(h') masquage à l'aide du sixième matériau des parties de cinquième matériau en surplomb,
(i') élimination des régions de cinquième matériau non recouvertes de sixième matériau,
(j') implantation d'ions d'un second type de conductivité dans les régions du substrat adjacentes aux parties en surplomb pour former les sources et les drains,
(k') réalisation d'espaceurs en un septième matériau isolant sur les flancs des parties de cinquième matériau en surplomb et élimination des régions de quatrième matériau non recouvertes de sixième matériau,
(l′) réalisation de premières lignes conductrices sur les sources et les drains, orientées parallèlement aux secondes bandes conductrices,
(m′) recouvrement des premières lignes conductrices d'un huitième matériau isolant,
(n′) réalisation du masque de lithographie présentant la forme de troisièmes bandes,
(o′) élimination des régions de cinquième, quatrième, second et troisième matériaux non masquées réalisant ainsi les empilements de grilles,
(p′) élimination du masque,
(q′) remplissage des espaces inter-empilements obtenus à l'étape (o′) d'un neuvième matériau, et
(r′) réalisation des secondes lignes conductrices sur les empilements, orientées perpendiculairement aux premières lignes conductrices.

Le premier matériau, qui peut être un matériau conducteur ou isolant, doit être différent du troisième matériau afin que ce dernier puisse être gravé indépendamment du premier matériau et vice versa.

En plus des avantages donnés ci-dessus, le procédé selon l'invention présente des simplifications notables par rapport aux procédés connus en réduisant le nombre de masques lithographiques à trois ; un masque pour définir l'emplacement des marches isolantes, un masque pour définir la largeur des empilements de grilles et un masque pour définir les dimensions des lignes conductrices servant à commander les empilements de grilles. En outre, ces masques présentent une configuration simple (bandes parallèles entre elles) et sont donc faciles à fabriquer.

D'autres caractéristiques et avantages de l'invention ressortiront mieux de la description qui va suivre, donnée à titre illustratif et non limitatif, en référence aux figures annexées, dans lesquelles :
- les figures 1 à 14 illustrent schématiquement les différentes étapes du procédé de fabrication de points mémoires EPROM selon l'invention : les figures 2 à 9 sont des coupes longitudinales, les figures 11, 12 et 14 des coupes transversales, les figures 1, 10a et 10b des vues en perspective et la figure 13 est une vue de dessus,
- les figures 15 et 16 illustrent une variante du procédé selon l'invention, et
- la figure 17 représente schématiquement en perspective, une cellule EPROM conforme à l'invention.

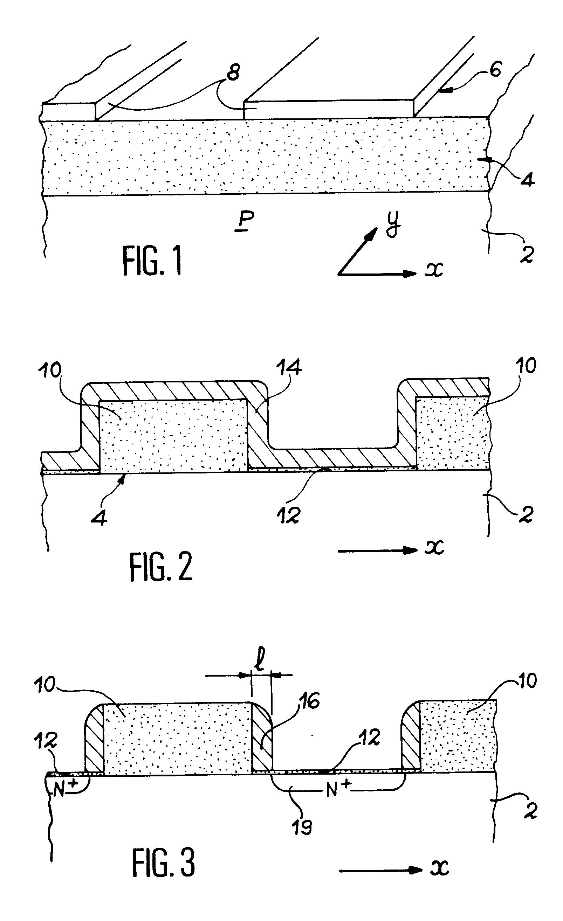

La première étape du procédé consiste, comme représenté sur la figure 1, à former sur un substrat semiconducteur 2 en silicium monocristallion de type p, d'orientation 100, une couche 4 d'oxyde de silicium (SiO₂) ayant une épaisseur de 1 µm. Cette couche 4 est obtenue par dépôt chimique en phase vapeur.

On réalise ensuite par photolithographie un premier masque 6 de résine servant à définir l'emplacement des différents points mémoires et en particulier l'emplacement des grilles flottantes. Ce masque 6 se présente sous la forme de bandes rectilignes 8 parallèles entre elles et à une direction y perpendiculaire au plan de coupe de la figure 1. La direction y correspond à la direction des lignes de mots de la cellule mémoire. Ces bandes 8 présentent une largeur constante et sont équidistantes ; elles sont espacées par exemple de 2,5 µm et présentent une largeur de 2,5 µm et une longueur de 2 mm.

Comme représenté sur la figure 2, on élimine alors les régions de la couche 4 non recouvertes de bandes de résine 8, afin de former des bandes d'oxyde de silicium 10 parallèles entre elles et la direction y. Cette élimination est réalisée par une gravure ionique réactive utilisant un plasma de CHF₃ pour une couche 4 en oxyde de silicium. La gravure est réalisée jusqu'à mise à nu des régions du silicium 2 non masquées.

Après élimination du masque de résine 6 par un plasma d'oxygène, on effectue alors une oxydation thermique à 900°C pendant 10 minutes des régions du substrat mises à nu pour former, entre les marches, une couche d'oxyde de silicium 12 d'environ 15 nm. Dans cet oxyde 12 sera défini ultérieurement l'oxyde de grille des grilles flottantes des points mémoires de la cellule mémoire.

Sur l'ensemble de la structure, on dépose ensuite de façon isotrope une couche 14 de silicium polycristallin dopé au phosphore par diffusion de POCl₃. Cette couche 14 déposée par un procédé de dépôt chimique en phase vapeur (CVD ou LPCVD) présente une épaisseur de 250 nm. Dans cette couche 14 seront réalisées ultérieurement les grilles flottantes des points mémoires.

On effectue alors une gravure pleine plaque (c'est-à-dire sans masque) de la couche 14 de silicium avec un plasma de SF₆ jusqu'à mise à nu des bandes isolantes 10, sur une épaisseur d'environ 250 nm, afin de ne laisser du silicium polycristallin que sur les flancs des bandes 10, comme représenté sur la figure 3. Ceci entraîne la formation de bandes conductrices 16, parallèles à la direction y, dont la largeur l est égale à l'épaisseur de la couche de silicium 14 et dans lesquelles seront définies les grilles flottantes des cellules mémoires. La longueur du canal de chaque cellule mémoire, défini sous la grille flottante de la cellule, est égale à l.

On réalise ensuite un dopage du substrat ayant une conductivité inverse de celle du substrat. Ce dopage peut être réalisé en implantant des ions d'arsenic pour un substrat 2 de type p, à une énergie de 100 keV et à une dose de 5.10¹⁵ at/cm². Ceci permet d'obtenir entre les bandes conductrices 16 des régions 19 de type N+ qui constitueront en partie les drains (en écriture) des points mémoires.

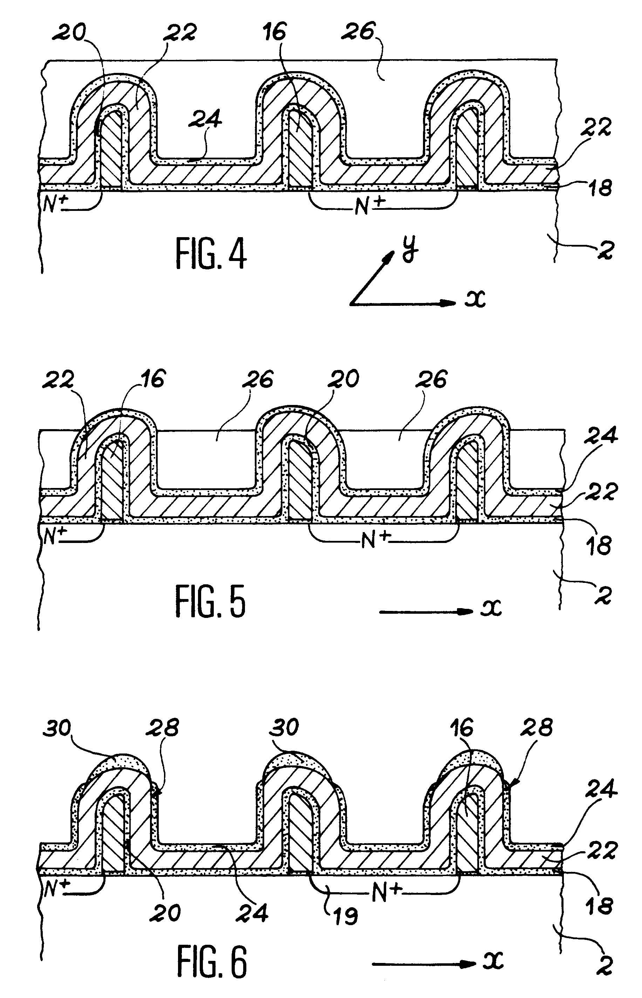

On effectue alors l'élimination des bandes de SiO₂ 10 en effectuant une attaque chimique sur 1µm d'épaisseur avec une solution d'acide fluorhydrique. Cette attaque chimique permet aussi l'élimination des régions de l'oxyde de silicium 12 mises à nu lors de la formation des espaceurs 16. La structurre obtenue est représentée sur la figure 4.

On réalise alors une oxydation thermique du silicium des bandes conductrices 16 et des régions du substrat mises à nu et situées entre les espaceurs 16 afin de former simultanément l'oxyde de grille 18 des grilles de commande des points mémoires de la cellule et l'oxyde 20 inter-grilles des points mémoires. Ces oxydes de silicium 18 et 20 sont réalisés par oxydation thermique à 900°C pendant 10 minutes afin d'obtenir un oxyde d'une épaisseur de 25 nm.

Sur les oxydes 18 et 20, on forme alors une autre couche de silicium polycristallin 22, dopé au phosphore par diffusion de POCl₃, dans laquelle seront réalisées ultérieurement les grilles de commande des points mémoires. Cette couche 22 déposée par la technique de dépôt chimique en phase vapeur (CVD ou LPCVD), présente une épaisseur de 250 nm.

On dépose ensuite sur la couche de silicium 22 une couche de nitrure de silicium 24 de 80 nm d'épaisseur environ par la technique de dépôt chimique en phase vapeur à basse pression (LPCVD).

On dépose ensuite sur la couche de nitrure 24 une couche de résine photosensible 26 telle que celle classiquement utilisée en photolithographie sur une épaisseurr de 1800 nm. Eventuellement, on effectue un traitement thermique de cette couche de résine, par exemple une cuisson à une température de l'ordre de 200°C pendant 15 minutes afin d'obtenir un bon étalement de la résine.

On réalise alors une gravure anisotrope par plasma d'O₂ de cette couche de résine afin de ne garder de la résine que dans les parties en creux du relief de la structure. La structure résultante est représentée sur la figure 5.

On élimine ensuite les régions de la couche de nitrure 24 non recouvertes de résine 26 à l'aide d'une gravure anisotrope du type ionique réactive en utilisant comme agent d'attaque du CHF₃. La gravure de la couche de nitrure 24 est réalisée afin de ne garder du nitrure qu'entre les bandes 28 parallèles d'empilement de matériaux et sur les flancs de ces bandes.

Après élimination du restant de la résine 26, en utilisant par exemple un plasma d'oxygène, on effectue alors une oxydation thermique du silicium polycristallin 22 mis à nu sur une épaisseur de 60 nm, à une température de 900°C pendant 30 minutes, formant ainsi des plots 30 de SiO₂, au-dessus des parties en surplomb 28, comme représenté sur la figure 6.

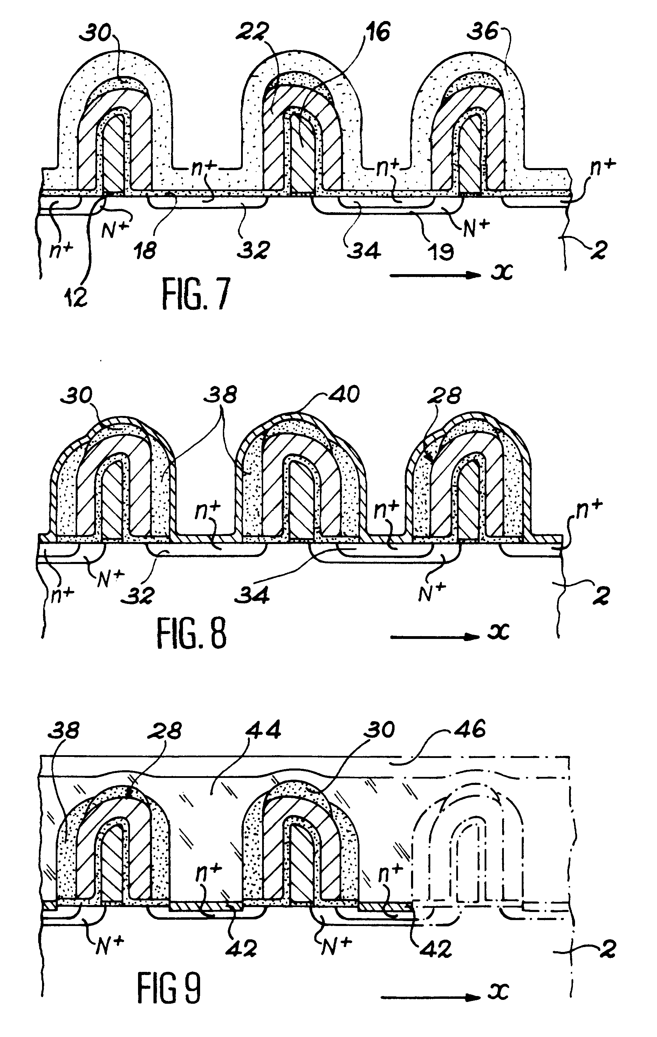

On élimine alors le restant de la couche de nitrure 24 par attaque chimique dans une solution de H₃PO₄ (figure 7).

Puis, on effectue une gravure pleine plaque de la couche de silicium polycristallin 22, afin d'éliminer le silicium présent entre les bandes 28 et de ne garder du silicium polycristallin que sous l'oxydation localisée 30. Ceci est réalisé par une gravure ionique réactive en utilisant comme agent d'attaque du SF₆.

On effectue alors la source et le drain des points mémoires en utilisant un dopage du substrat 2 ayant une conductivité inverse de ce dernier. Pour un substrat en silicium de type p, ce dopage peut être réalisé en implantant des ions d'arsenic à une dose de 5.10¹⁵ at/cm² avec une énergie de 100 keV. Les zones implantées 32 servent de sources et les zones 34 associées aux zones 19 servent de drains, lors de l'écriture d'une information.

Les étapes précédentes permettent d'obtenir des cellules mémoires dont la source 32 est non recouverte par la grille de commande à l'inverse du drain, ce qui correspond au recouvrement partiel du canal des cellules mémoires par leur grille de commande. Un tel agencement permet d'éviter les courants de fuite.

On dépose ensuite une couche d'oxyde de silicium 36, présentant une épaisseur de 300 nm environ de façon isotrope par exemple par un procédé de dépôt chimique en phase vapeur à basse pression. La structure résultante est représentée sur la figure 7.

On effectue alors, comme représenté sur la figure 8, une gravure de cette couche 36 afin de ne garder que des bandes isolantes ou espaceurs 38 sur tous les flancs gravés des empilements de matériaux 28. Ces espaceurs 38 sont obtenus par une gravure anisotrope du type ionique réactive en utilisant du CHF₃ comme agent d'attaque.

Ces espaceurs 38 ont une largeur de 300 nm définie par l'épaisseur de la couche 36 de SiO₂ déposée de façon isotrope. Cette gravure est une gravure pleine plaque. Elle permet en outre d'éliminer l'oxyde de silicium 18 situé entre deux espaceurs consécutifs 38.

On effectue alors un traitement thermique de la structure par exemple à 850°C pendant 30 minutes, afin d'activer électriquement les ions des sources et drains implantés dans le substrat.

On dépose ensuite une couche 40, sur l'ensemble de la structure en un métal apte à former un siliciure. Cette couche est en particulier une couche de titane d'environ 30 nm d'épaisseur déposée par pulvérisation magnétron.

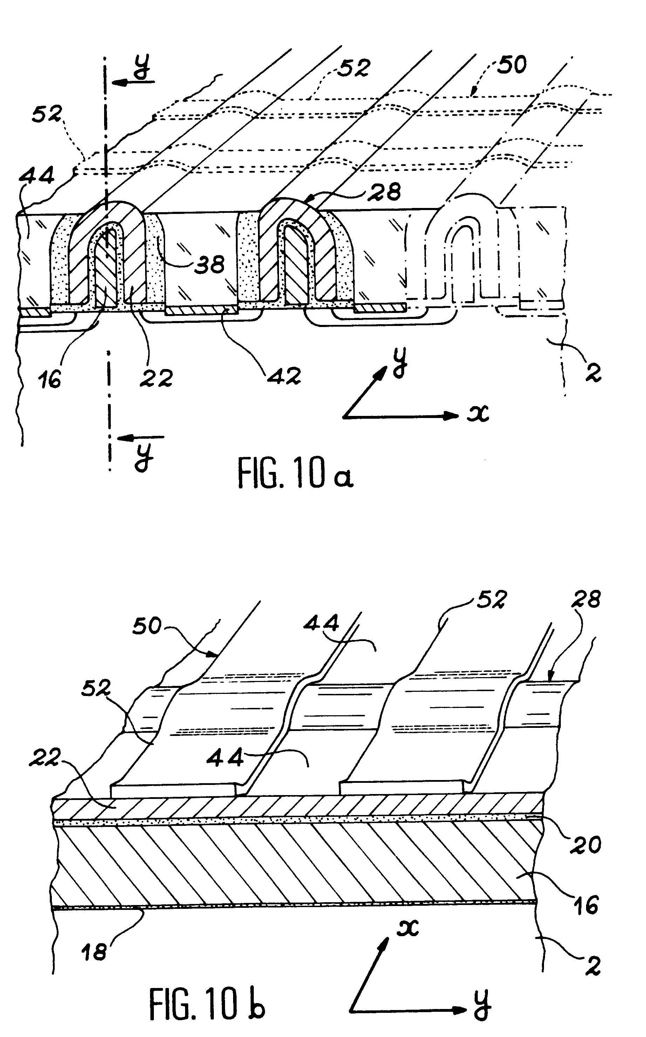

L'ensemble de la structure est ensuite soumis à un recuit à une température de 600°C pendant 15 minutes environ, en atmosphère de gaz neutre (N₂ par exemple). Ce recuit permet de former un siliciure 42 (TiSi₂), comme représenté sur la figure 9, par réaction du métal (titane) avec le silicium du substrat 2 au contact l'un de l'autre, entre les espaceurs 38, c'est-à-dire sur les sources 32 et les drains 19, 34.

On élimine ensuite les parties de la couche 40 non en contact avec le silicium et n'ayant pas par conséquent formé de siliciure. L'élimination sélective du titane par rapport au siliciure de titane est effectuée par voie chimique en utilisant un mélange d'acide nitrique et d'acide fluorhydrique. Les lignes conductrices 42 obtenues servent à véhiculer les signaux électriques devant être appliqués sur les sources et les drains, lors de l'écriture ou de la lecture d'information dans la cellule mémoire.

On dépose ensuite une couche isolante 44 d'environ 800 nm d'épaissseur réalisée en verre phosphosilicaté (PSG) ou en verre borophosphosilicaté (BPSG) par une technique de dépôt chimique en phase vapeur. On effectue alors un traitement thermique de cette couche 44 en vue de la faire fluer et de la densifier, par exemple à une température de 850°C pendant 30 minutes.

Cette couche isolante 44 est ensuite recouverte d'une couche de résine photosensible 46 "de planarisation", d'environ 1800 nm. Un traitement thermique par exemple un chauffage à une température de 200°C pendant une demi-heure, permet d'obtenir un bon étalement de cette couche de résine.

On effectue ensuite une gravure simultanée de la couche de résine 46, du verre 44 et de l'oxyde localisé 30, à des vitesses d'attaque identiques pour la résine, le verre et l'oxyde jusqu'à ce que le silicium polycristallin 22 du sommet des bandes 28 soit mis à nu. La structure obtenue est celle représentée sur les figures 10a et 10b.

Cette gravure est réalisée de façon anisotrope par une gravure de type ionique réactive en utilisant des agents fluorés (CHF₃ ou CF₄) et de l'oxygène, les composés fluorés servant à graver l'oxyde et le verre et l'oxygène à graver la résine.

L'étape suivante du procédé consiste, comme représenté sur la figure 10a, à former un nouveau masque lithographique 50 de résine photosensible définissant la longueur des empilements de grilles et donc la largeur du canal. Ce masque 50 se présente donc sous forme de bandes 52 parallèles à la direction x. Ces bandes 52 présentent une largeur de 1,2 µm et sont séparées les unes des autres de 1,2 µm.

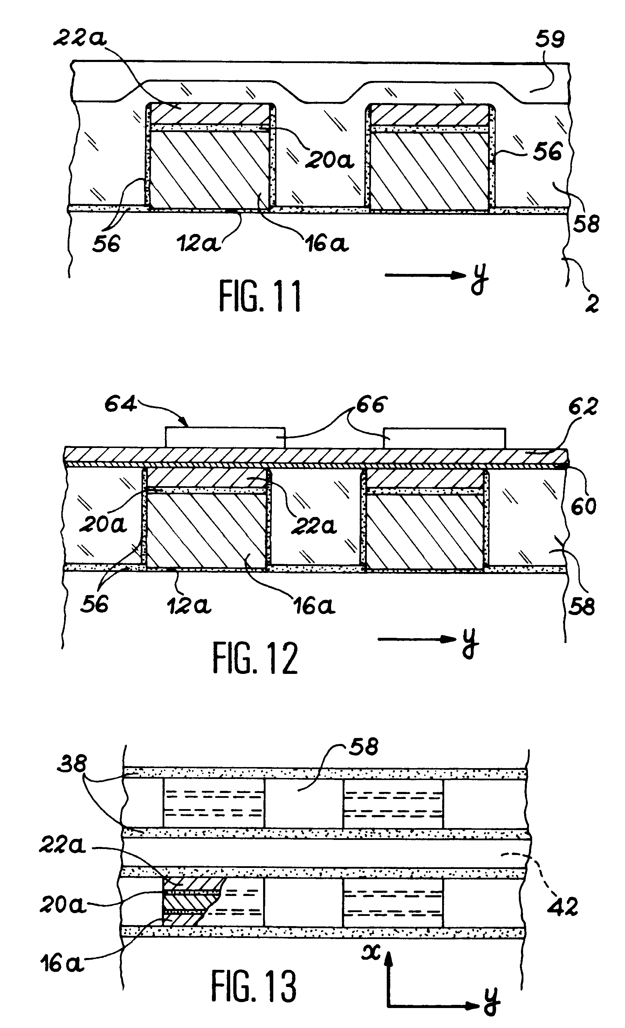

A l'aide de ce masque, on élimine, comme représenté sur la figure 11, les régions des bandes 28 des couches successives 22, 20, 14, 18 non recouvertes par les bandes de résine 52 du masque 50. Cette élimination est réalisée par des gravures anisotropes successives du type ionique réactive utilisant comme agent d'attaque du CHF₃ pour les couches en SiO₂ 20, 18 et 12 et du SF₆ pour les couches en silicium 22 et 14.

Cette gravure est réalisée jusqu'à mise à nu du substrat. La structure est représentée sur la figure 11. Les empilements 54 des grilles flottantes 16a et de commande 22a sont alors achevés ; les isolants de grille et d'inter-grilles portent respectivement les références 12a et 20a.

Après élimination du masque de résine 50 par un plasma d'oxygène, on effectue une oxydation thermique 56 des régions du substrat 2 mises à nu et des flancs gravés des empilements 54 d'une épaisseur de 50 nm, à une température de 900°C pendant 20 minutes.

On dépose ensuite une couche 58 isolante de verre borophosphosilicaté par exemple sur une épaisseur de 800 nm par la technique de dépôt chimique en phase vapeur. On effectue alors un traitement thermique de cette couche 58 en vue de la faire fluer et de la densifier, par exemple à une température de 850°C pendant 30 minutes.

Cette couche 58 est ensuite recouverte d'une couche de résine 59 photosensible "de planarisation" sur une épaisseur de 1800 nm. Un chauffage à une température de 200°C pendant 1/2 heure permet d'obtenir un bon étalement de cette couche de résine 60.

On effectue alors une gravure simultanée de la couche de résine 59 et du verre BPSG 58 jusqu'à ce que le silicium 22 des empilements 54 des grilles soit mis à nu. La structure obtenue est celle représentée sur la figure 12. Cette gravure est réalisée de façon anisotrope par une gravure du type ionique réactive en utilisant des agents fluorés (CHF₃ ou CF₄) pour graver le verre et de l'oxygène pour graver la résine.

La structure obtenue après cette gravure est représentée sur la figure 13 en vue de dessus.

L'étape suivante du procédé (figure 12) consiste à déposer deux couches conductrices superposées 60 et 62 respectivement en TiW et Al de respectivement 100 nm et 600 nm, déposées par pulvérisation magnétron.

On réalise alors un troisième masque de résine photosensible 64 identique au masque 50 et comportant en outre des bandes 66, parallèles à la direction x, de 1,2 µm de largeur et séparées de 1,2 µm les unes des autres. Ce masque permet de définir les dimensions des lignes de mots, c'est-à-dire celles des lignes conductrices de commande des empilements 54 de grilles.

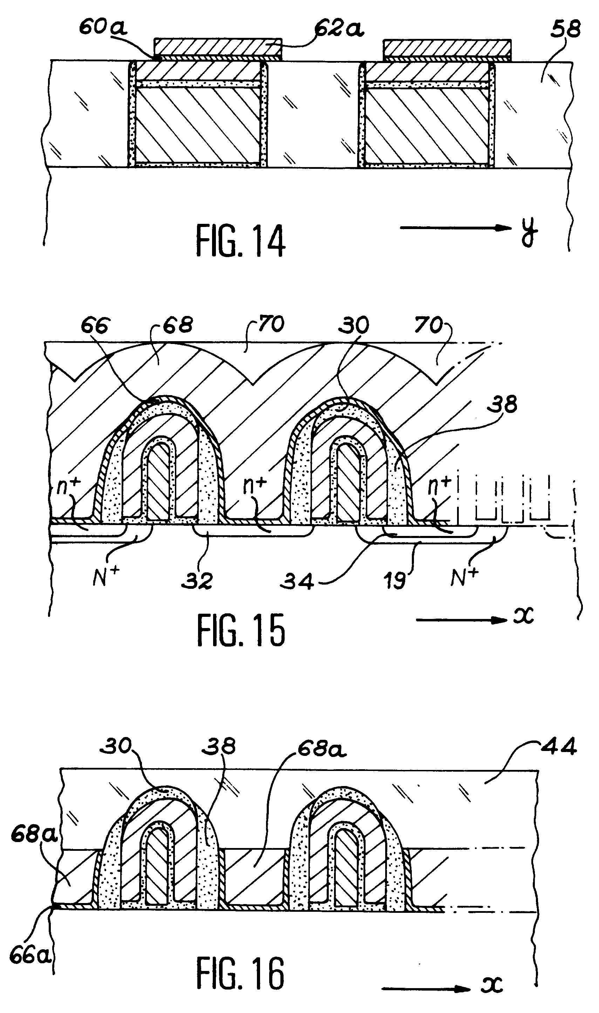

A l'aide de ce masque 64, on effectue alors une gravure des couches 62 et 60 afin d'éliminer les régions de ces couches non recouvertes de résine. La structure obtenue est celle représentée sur la figure 14. Cette gravure est réalisée par une gravure anisotrope du type ionique réactive en utilisant comme agent d'attaque du CCl₄ pour la couche 62 en aluminium et du SF₆ pour la couche 60 en TiW. On obtient alors des lignes conductrices 60a, 62a de commande des grilles ayant la forme de bandes parallèles à x.

La dernière étape du procédé consiste à éliminer le masque 64 avec un plasma d'oxygène.

Le procédé selon l'invention décrit précédemment permet d'obtenir une structure quasi-plane. En outre, ce procédé ne fait intervenir que trois niveaux de masquage 6, 50 et 64 formés chacun de bandes parallèles entre elles et donc de constitution relativement simple.

Sur les figures 15 et 16, on a représenté une variante du procédé décrit ci-dessus consistant à remplacer les lignes conductrices 42 en siliciure par des lignes conductrices bicouches en nitrure de titane et tungstène.

Après réalisation des espaceurs 38 et du recuit d'implantation des sources et des drains 32 et 19, 34 des points mémoires on dépose une couche 66 de nitrure de titane TiN de 100 nm d'épaisseur puis une couche 68 de tungstène de 800 nm d'épaisseur par pulvérisation magnétron. La couche de TiN 66 sert de barrière de diffusion afin d'éviter toute réaction entre le métal de la couche 68 et le silicium lors des traitements thermiques ultérieurs.

On dépose ensuite une couche de résine photosensible 70 par exemple de 1800 nm d'épaisseur que l'on soumet à un traitement thermique de l'ordre de 200°C pendant 15 minutes afin d'obtenir un bon étalement de cette couche.

On réalise alors une gravure de cette couche de résine 70 afin de ne garder de la résine que dans les parties en creux du relief de la structure, comme représenté sur la figure 15.

On effectue alors une gravure des couches 68 et 66 et simultanément l'élimination de la résine 70. Cette gravure est réalisée de façon anisotrope avec une gravure du type ionique réactive en utilisant du SF6 pour la couche en TiN et la couche en W. Cette gravure est réalisée sur une hauteur de 500 nm environ en-dessous des bandes 28. La structure obtenue est celle représentée sur la figure 16 et les lignes conductrices obtenues portent les références 66a, 68a. On effectue ensuite comme précédemment le dépôt de la couche de verre 44.

On décrit ci-après la cellule mémoire EPROM obtenue par le procédé de l'invention.

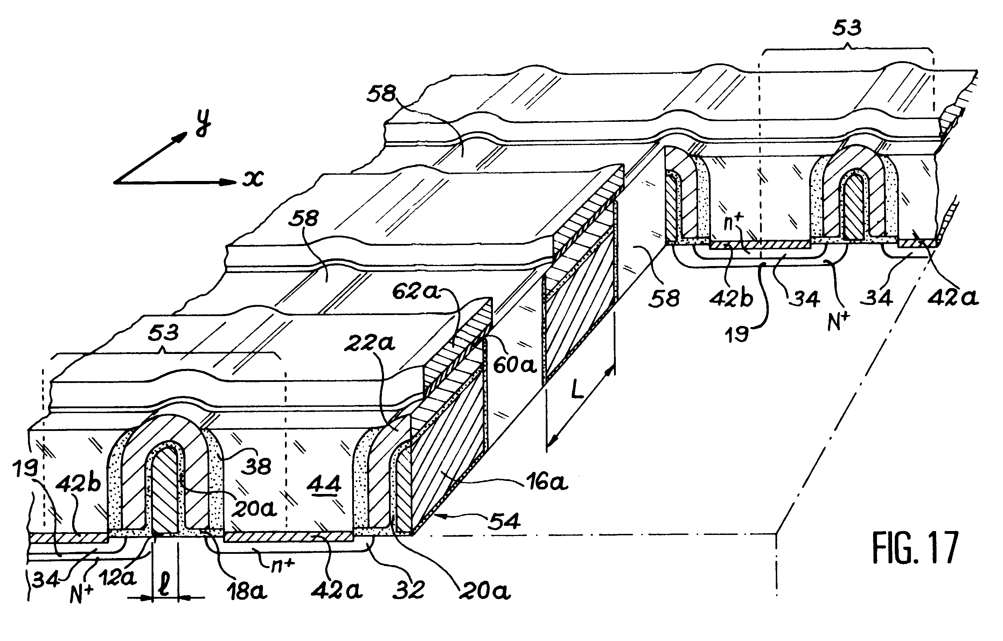

La cellule mémoire EPROM, représentée sur la figure 17 comporte, comme les cellules mémoires de l'art antérieur, une matrice de points mémoires 53 comportant chacun une source 32 et un drain 19, 34 de type n⁺ réalisés dans un substrat 26 en silicium monocristallin de type p. Des empilements 54 de grilles sont prévus entre les sources et les drains. Les canaux des points mémoires allant de la source au drain sont orientés suivant une direction x.

Ces empilements 58, en partant du substrat 26, sont formés d'un isolant de grille 12a en oxyde de silicium de 15 nm d'épaisseur, d'une grille flottante 16a en silicium polycristallin dopé au phosphore en contact avec l'isolant 12a, d'un isolant inter-grille 20a formé de SiO₂ de 25 nm d'épaisseur, d'une grille de commande 22a en silicium polycristallin dopé au phosphore de 250 nm d'épaisseur.

Ces empilements ont typiquement une hauteur comprise entre 1000 et 1500 nm contre 600 à 700 nm dans l'état de la technique.

Selon l'invention, la grille flottante 16a de chaque point mémoire présente dans un plan (celui des figures 1 à 9), perpendiculaire à la surface du substrat et contenant la direction x des canaux des points mémoires, la forme d'un plot de largeur l de 250 nm environ, de longueur L de 1,2 µm environ et de hauteur 1 µm. Elle est coiffée sur trois de ses côtés par l'isolant inter-grilles 22a, présentant alors la forme d'un U renversé, dans le plan perpendiculaire à la surface du substrat et contenant la direction x.

Ce U en matériau isolant est lui-même entièrement logé dans la grille de commande 22a présentant aussi la forme d'un U renversé dans le plan perpendiculaire à la surface du substrat et contenant la direction x. Afin d'isoler électriquement la grille de commande 22a du substrat un isolant de grille 18a est prévu aux extrémités des branches du U ; cet isolant est du SiO₂ de 25 nm d'épaisseur.

Le U de la grille de commande 22a ne comporte aucun prolongement dans la direction x, ce qui contribue à l'augmentation de la densité d'intégration de la mémoire. Par ailleurs, la grille de commande 22a recouvre partiellement le drain 19, 34 de la cellule mémoire et donc le canal présent sous la grille flottante 16a. Ceci entraîne la formation d'un second canal adjacent au premier.

Afin d'isoler électriquement les uns des autres les points mémoires 55, des isolations latérales 58 ou 44 sont prévues. Ces isolations peuvent être réalisées en oxyde de silicium (SiO₂) dopé au phosphore, en verre phosphosilicaté ou en verre borophosphosilicaté. En outre des espaceurs 38 en SiO₂ sont prévus, de part et d'autre des empilements 54. Ces espaceurs 38 présentent la forme de bandes, orientées selon la direction y perpendiculaire aux canaux des points mémoires.

Conformément à l'invention, la grille flottante 16a et la grille de commande 22a des différents points mémoires ne s'étendent pas au-dessus des isolations latérales 38, 58, 44 et sont auto-alignées (ou auto-positionnées) par rapport à ces isolations.

Selon l'invention, la connexion des grilles de commande 22a entre elles, correspondant aux lignes de mots, est réalisée par des bandes conductrices 60a, 62a métalliques, orientées parallèlement à la direction x des points mémoires. Ces bandes peuvent être réalisées d'un bicouche TiW-Al, le TiW étant au contact des grilles de commande 22a.

Par ailleurs, la connexion des drains 34 des points mémoires, correspondant aux lignes d'éléments binaires, est réalisée à l'aide de bandes conductrices 42a parallèles à la direction y qui est perpendiculaire aux lignes métalliques de connexion des grilles et donc aux canaux des points mémoires.

De même la connexion des sources 32 des points mémoires, correspondant aux lignes d'alimentation des points mémoires est réalisée par des bandes conductrices 42b, parallèles aux bandes conductrices 42a de connexion des drains.

Les lignes d'éléments binaires et d'alimentation sont réalisées en une ou plusieurs couches de métal (Al, W, Ta, Mo etc) ou en un siliciure d'un métal réfractaire tel que TiSi₂, TaSi₂, MoSi₂, WSi₂, PtSi.

Pour lire le contenu d'un point mémoire particulier, il faut polariser les lignes d'éléments binaires 42a en leur appliquant une tension de 5 volts et mettre la ligne d'alimentation 42b correspondante à la masse, les autres lignes d'alimentation n'étant pas polarisées. Ceci est nécessaire étant donné que deux points mémoires voisins, qui partagent la même ligne d'éléments binaires 42a sont activés par la même ligne de mots 60a-62a.

La tension appliquée sur les lignes d'alimentation et sur les lignes de mots aussi bien en écriture qu'en lecture est de l'ordre de 5 volts.

En écriture, les rôles des sources et des drains sont inversés par rapport à la lecture.

La description donnée ci-dessus n'a bien entendu été donnée qu'à titre d'exemple, toute modification sans pour autant sortir du cadre de l'invention, pouvant être envisagée. En particulier, il est possible de modifier l'épaisseur des différentes couches, de remplacer les couches isolantes d'oxyde de silicium par des couches de nitrure de silicium et de remplacer les couches conductrices en silicium polycristallin par d'autres métaux conducteurs tels que des métaux réfractaires ou des siliciures.

De même il est possible de remplacer toutes les gravures ioniques réactives par d'autres types de gravures sèches ou humides généralement utilisées en micro-électronique. En outre pour de couches réalisées en matériau difficile à graver telles que des couches de cuivre ou d'argent, on peut utiliser des usinages ioniques.

La description ci-dessus ne se réfère qu'à la fabrication d'une cellule mémoire EPROM. Dans le cas d'une cellule mémoire EEPROM du type flash, il suffit simplement d'utiliser un oxyde de grille 12a de 10 nm au lieu de 15 nm. Dans une telle cellule, l'écriture et la lecture d'une information se font comme dans une cellule EPROM et l'effacement se fait en appliquant 5 (ou 10) volts sur la ligne d'alimentation 42b correspondante et -5 (ou 0) volts sur la ligne de mots correspondante.

Le fait que la grille de commande de chaque cellule mémoire recouvre partiellement le canal de la cellule permet d'éviter ou du moins de contrôler les courants de fuites, ce qui est particulièrement avantageux pour les cellules mémoires EEPROM. Ceci permet en outre l'obtention de deux canaux adjacents (split gate en terminologie anglo-saxonne) et donc l'obtention d'une cellule mémoire EEPROM associée à un transistor de sélection qui permet d'éviter les inconvénients du sur-effacement (négative-threshold en terminologie anglo-saxonne).

L'importance du transistor de sélection pour chaque cellule mémoire est soulignée dans l'article de S.K. Lai et al "VLSI electrically erasable programmable read only memory", VLSI Handbook (1985), p. 167-168. Le deuxième rôle joué par le transistor de sélection qui est d'empêcher l'effacement des cellules non sélectionnées d'une même colonne de la matrice de cellules mémoires est abandonné dans les mémoires EEPROM du type flash puisque l'effacement a justement lieu, à la fois, sur toutes les cellules d'une même colonne.

Enfin, la description précédente ne se rapporte qu'à la fabrication de la cellule mémoire ou mémoire proprement dite ; les circuits périphériques et de commande, situés dans le même plan que la cellule mémoire sont réalisés de façon classique et ne font pas l'objet de la présente invention.

## Revendications

1. Cellule mémoire non volatile intégrée sur un substrat semiconducteur (2) comportant (a) une matrice de points mémoires (53) isolés électriquement et latéralement les uns des autres, chaque point mémoire (53) comprenant un empilement de grilles (54) formé d'un premier isolant (12a) en contact avec le substrat (2), d'une grille flottante (16a) et d'une grille de commande (22a) séparées l'une de l'autre par un second isolant (20a), la grille flottante comportant une face en contact avec le premier isolant, une source (32) et un drain (19, 34) formés dans le substrat (2) de part et d'autre de l'empilement de grilles (54), et un canal situé dans le substrat sous ledit empilement, dont la longueur est orientée selon une première direction (x) allant de la source au drain, et (b) des lignes conductrices (60a, 62a, 42a, 66a, 68a) servant à appliquer des signaux électriques sur les empilements de grilles (54) et sur les drains, caractérisée en ce que le second isolant (20a) présente, dans un plan perpendiculaire à la surface du substrat et contenant la première direction (x), la forme d'un U renversé à l'intérieur duquel est logée entièrement la grille flottante (16a) et en ce que la grille de commande (22a) présente aussi la forme d'un U renversé ne comportant pas de prolongement selon la première direction (x), à l'intérieur duquel est logé entièrement le second isolant (20a), la grille de commande ne débordant pas sur les isolations latérales (58) aussi bien selon la première direction (x) que selon une seconde direction (y) perpendiculaire à la première.

2. Cellule mémoire selon la revendication 1, caractérisée en ce que la grille flottante (16a) présente une hauteur au moins deux fois plus grande que sa largeur.

3. Cellule mémoire selon la revendication 1 ou 2, caractérisée en ce que la largeur de la grille flottante (16a) est inférieure à 0,5 µm.

4. Cellule mémoire selon l'une quelconque des revendications 1 à 3, caractérisée en ce que le premier isolant (12a) présente une épaisseur inférieure à celle du second isolant (20a).

5. Cellule mémoire selon l'une quelconque des revendications 1 à 4, caractérisée en ce que les lignes conductrices (60a, 62a) servant à commander les empilements de grilles (54) sont constituées de bandes parallèles à la première direction et en ce que les lignes conductrices (42a, 66a, 68a) servant à commander les drains (19, 34) sont perpendiculaires à la première direction.

6. Cellule mémoire selon l'une quelconque des revendications 1 à 5, caractérisée en ce que les lignes (42a, 66a, 68a) de commande des drains (19, 34) sont réalisées en une couche métallique ou en une couche de siliciure.

7. Cellule mémoire selon la revendication 6, caractérisée en ce qu'une couche (66a) servant de barrière anti-diffusion des lignes (68a) de commande des drains en métal dans le substrat semiconducteur (2) est prévue.

8. Cellule mémoire selon l'une quelconque des revendications 1 à 6, caractérisée en ce que les lignes conductrices (60a, 62a) servant à commander les empilements de grilles (54) sont réalisées en métal.

9. Cellule mémoire selon l'une quelconque des revendications 1 à 8, caractérisée en ce que la grille de commande (22a) recouvre partiellement le drain (19, 34) et donc ledit canal et non la source (32).

10. Procédé de fabrication d'une cellule mémoire non volatile intégrée sur un substrat semiconducteur (2) comportant (a) une matrice de points mémoires (53) isolés électriquement les uns des autres par des isolations latérales (38, 44, 58), chaque point mémoire (53) comprenant une grille flottante (16a) et une grille de commande (22a) empilées, isolées l'une de l'autre, une source (32) et un drain (19, 34) situés de part et d'autre de l'empilement de grilles (54) et un canal situé sous ledit empilement, dont la longueur est orientée selon une première direction (x) allant de la source au drain, et (b) des lignes conductrices (60a, 62a, 42a, 66a, 68a) servant à appliquer des signaux électriques sur les empilements de grilles (54) et sur les drains (34) des points mémoires, caractérisé en ce que les grilles flottantes (16a) sont réalisées en déposant de façon isotrope sur des marches (10) en un premier matériau une couche (14) d'un second matériau conducteur que l'on peut graver sélectivement par rapport au premier matériau, en gravant la couche de second matériau de façon anisotrope jusqu'à mise à nu des marches, en formant les drains des points mémoires, en éliminant les marches de premier matériau et en ce qu'on réalise ensuite les grilles de commande isolées des grilles flottantes, les sources des points mémoires puis les lignes conductrices.

11. Procédé de fabrication sellon la revendication 10, caractérisé en ce que l'on forme les empilements de grilles en effectuant les étapes successives suivantes :
(a) réalisation des marches (10) de premier matériau sur un substrat semiconducteur (2) d'un premier type de conductivité, ces marches ayant la forme de premières bandes orientées perpendiculairement à la première direction (x),
(b) dépôt d'un troisième matériau isolant (12) sur le substrat, entre les marches,
(c) dépôt isotrope, sur les marches et le troisième matériau, de la couche (14) de second matériau,
(d) gravure anisotrope de la couche de second matériau afin d'obtenir des secondes bandes conductrices (16) parallèles aux premières bandes,
(e) élimination des marches (10) et des régions du troisième matériau non recouvertes de second matériau,
(f) dépôt d'un quatrième matériau (18, 20) isolant sur les régions du substrat mises à nu lors de l'étape (e) et sur les secondes bandes conductrices,
(g) dépôt d'un cinquième matériau conducteur (22) sur le quatrième matériau présentant des parties en surplomb (28) en regard des secondes bandes conductrices,
(h) masquage (30) à l'aide d'un sixième matériau des parties de cinquième matériau en surplomb,
(i) élimination des régions de cinquième et de quatrième matériaux non recouvertes de sixième matériau,
(j) réalisation d'un masque de lithographie (50) présentant la forme de troisièmes bandes (52) orientées perpendiculairement aux secondes bandes et définissant la longueur des empilements (54),
(k) élimination des régions de cinquième, quatrième, second et troisième matériaux non masquées réalisant ainsi les empilements de grilles (54), et
(l) élimination du masque (50).

12. Procédé de fabrication selon la revendication 10 ou 11, caractérisé en ce qu'il comprend les étapes successives suivantes :
(a') réalisation des marches (10) de premier matériau sur le substrat semiconducteur,
(b') dépôt du troisième matériau isolant (12) sur le substrat, entre les marches (10),
(c') dépôt isotrope sur les marches et le troisième matériau de la couche (14) de second matériau,
(d') gravure anisotrope de la couche de second matériau afin d'obtenir les secondes bandes conductrices (16) puis implantations d'ions d'un second type de conductivité entre ces secondes bandes pour former en partie les drains (19),
(e') élimination des marches (10) et des régions du troisième matériau non recouvertes de second matériau,
(f') dépôt du quatrième matériau (18, 20),
(g') dépôt du cinquième matériau conducteur (22) sur le quatrième matériau,
(h') masquage (30) à l'aide du sixième matériau des parties (28) de cinquième matériau en surplomb,
(i') élimination des régions de cinquième matériau non recouvertes de sixième matériau,
(j') implantation d'ions d'un second type de conductivité dans les régions du substrat adjacentes aux parties en surplomb pour former les sources (32) et les drains (34),
(k') réalisation d'espaceurs (38) en un septième matériau isolant sur les flancs des parties de cinquième matériau en surplomb et élimination des régions de quatrième matériau (18) non recouvertes de sixième matériau,
(l') réalisation de premières lignes conductrices (42a, 42b, 66a, 68a) sur les sources et les drains, orientées parallèlement aux secondes bandes conductrices,
(m') recouvrement des premières lignes conductrices d'un huitième matériau isolant (44),
(n') réalisation du masque de lithographie (50) présentant la forme de troisièmes bandes (52),
(o') élimination des régions de cinquième, quatrième, second et troisième matériaux non masquées réalisant ainsi les empilements de grilles (54),
(p') élimination du masque (50),
(q') remplissage des espaces inter-empilements obtenus à l'étape (o') d'un neuvième matériau (58), et
(r') réalisation des secondes lignes conductrices (60a, 62a) sur les empilements (54), orientées perpendiculairement aux premières lignes conductrices.

13. Procédé de fabrication selon la revendication 12, caractérisé en ce que le substrat (2) étant réalisé en silicium, l'étape de réalisation des premières lignes conductrices (42a, 42b) comprend les étapes suivantes :
- dépôt sur la structure obtenue lors de l'étape (k') d'une couche (40) d'un métal apte à former un siliciure,
- recuit thermique de l'ensemble afin de faire réagir le métal directement au contact des régions du substrat mises à nu pour former localement un siliciure (42), et
- élimination des régions du métal n'ayant pas réagi avec le substrat.

14. Procédé de fabrication selon la revendication 12, caractérisé en ce que l'étape de réalisation des premières lignes conductrices (66a, 68a) comprend les étapes suivantes :
- dépôt sur la structure obtenue lors de l'étape (k') d'une couche d'au moins un dixième matériau (66, 68) conducteur,
- dépôt sur le dixième matériau d'une couche de résine (70) effaçant le relief du dixième matériau,
- gravure de la couche de résine afin de ne garder de la résine que dans les parties en creux du relief du dixième matériau (66, 68),
- gravure du dixième matériau et élimination de la résine (70).

15. Procédé de fabrication selon l'une quelconque des revendications 10 à 14, caractérisé en ce que les premier, troisième, quatrième, sixième et/ou septième matériaux sont réalisés en oxyde de silicium (SiO₂).

16. Procédé de fabrication selon l'une quelconque des revendications 10 à 15, caractérisé en ce que le second et/ou le cinquième matériaux sont réalisés en silicium polycristallin dopé au phosphore.

## Claims

1. Integrated non-volatile storage cell on a semiconductor substrate (2) having (a) a matrix of storage points (53) which are electrically and laterally insulated from one another, each storage point (53) incorporating a stack of gates (54) formed by a first insulant (12a) in contact with the substrate (2), a floating gate (16a) and a control gate (22a) separated from one another by a second insulant (20a), the floating gate having a face in contact with the first insulant, a source (32) and a drain (19, 34) formed in the substrate (2) on either side of the stack of gates (54) and a channel located in the substrate beneath said stack and whose length is oriented in accordance with a first direction (x) passing from the source to the drain and (b) conductor lines (60a, 62a, 42a, 66a, 68a) for applying electric signals to the stacks of gates (54) and to the drains, characterized in that the second insulant (20a) has, in a plane perpendicular to the surface of the substrate and containing the first direction (x), the shape of an inverted U within which is entirely located the floating gate (16a) and in that the control gate (22a) is also shaped like an inverted U, having no extension in accordance with the first direction (x) and within which is entirely located the second insulant (20a), the control gate not projecting over the lateral insulations (58), both in accordance with the first direction (x) and in accordance with a second direction (y) perpendicular to the first direction.

2. Storage cell according to claim 1, characterized in that the floating gate (16a) has a height which is at least twice its width.

3. Storage cell according to claim 1 or 2, characterized in that the width of the floating gate (16a) is less than 0.5 µm.

4. Storage cell according to any one of the claims 1 to 3, characterized in that the first insulant (12a) has a thickness less than that of the second insulant (20a).

5. Storage cell according to any one of the claims 1 to 4, characterized in that the conductor lines (60a, 62a) for controlling the stacks of gates (54) are constituted by strips parallel to the first direction and in that the conductor lines (42a, 66a, 68a) for controlling drains (19, 34) are perpendicular to the first direction.

6. Storage cell according to any one of the claims 1 to 5, characterized in that the control lines (42a, 66a, 68a) of drains (19, 34) are produced from a metal layer or a silicide layer.

7. Storage cell according to claim 6, characterized in that a layer (66a) serving as an anti-diffusion barrier for the drain control lines (68a) is provided for preventing metal diffusing into the semiconductor substrate (2).

8. Storage cell according to any one of the claims 1 to 6, characterized in that the conductor lines (60a, 62a) for controlling the stacks of gates (54) are made from a metal.

9. Storage cell according to any one of the claims 1 to 8, characterized in that the control gate (22a) partly covers the drain (19, 34) and therefore the channel, but not the source (32).

10. Process for the production of a non-volatile storage cell integrated onto a semiconductor substrate (2) having (a) a matrix of storage points (53) electrically insulated from one another by lateral insulations (38, 44, 58), each storage point (53) having a floating gate (16a) and a control gate (22a) in stacked form and which are insulated from one another, a source (32) and a drain (19, 34) located on either side of the stack of gates (54) and a channel located beneath said stack, whose width is oriented in accordance with a first direction (x) from the source to the drain and (b) conductor lines (60a, 62a, 42a, 66a, 68a) for applying electric signals to the stacks of gates (54) and to the drains (34) of the storage points, characterized in that the floating gates (16a) are produced by isotropically depositing on steps (10) of a first material a layer (14) of a second conductor material which can be selectively etched with respect to the first material, followed by anisotropically etching the layer of second material until the steps are exposed, by forming drains of storage points, eliminating the first material step and in that then control gates insulated from the floating gates are produced, followed by the sources of the storage points and then the conductor lines.

11. Production process according to claim 10, characterized in that the stacks of gates are formed by performing the following successive stages:
(a) producing steps (10) of a first material on a semiconductor substrate (2) of a first conductivity type, said steps being in the form of small strips oriented perpendicular to the first direction (x),
(b) deposition of a third insulating material (12) on the substrate between the steps,
(c) isotropic deposition on the steps and the third material of the layer (14) of the second material,
(d) anisotropic etching of the second material layer in order to obtain second conductive strips (16) parallel to the first strips,
(e) elimination of the steps (10) and regions of the third material not covered by the second material,
(f) deposition of a forth insulating material (18, 20) on the regions of the substrate exposed during stage (e) and on the second conductive strips,
(g) deposition of a fifth conductive material (22) on the fourth material having overhanging (28) parts facing the second conductive strips,
(h) masking (30) with the aid of a sixth material of overhanging fifth material parts,
(i) elimination of the regions of the fifth and fourth materials not covered by the sixth material,
(j) producing a lithography mask (50) in the form of third strips oriented perpendicular to the second strips (52) and defining the length of the stacks (54),
(k) elimination of the regions of the fifth, fourth, second and third materials which are not masked, thus producing the stack of gates (54), and
(l) elimination of the mask (50).

12. Production process according to claim 10 or 11, characterized in that it comprises the following successive stages:
(a') producing steps (10) of a first material on the semiconductor substrate,
(b') deposition of the third insulating material (12) on the substrate between the steps,
(c') isotropic deposition on the steps (10) and the third material of the second material layer (14),
(d') anisotropic etching of the second material layer to obtain the second conductive strips (16),
(e') elimination of the steps (10) and regions of the third material not covered by the second material,
(f') deposition of the fourth material (18, 20),
(g') deposition of the fifth conductive material (22) on the fourth material,
(h') masking (30) with the aid of the sixth material of overhanging fifth material parts,
(i') elimination of regions of the fifth material not covered by the sixth material,
(j') implanting ions of a second conductivity type in the regions of the substrate adjacent to the overhanging parts to form the sources (32) and drains (19, 34),
(k') producing spacers (38) of a seventh insulating material on the edges of the overhanging fifth material parts and elimination of the fourth material (18) regions not covered by the sixth material,
(l') producing first conductor lines (42a, 42b, 66a, 68a) on the sources and drains oriented parallel to the second conductive strips,
(m') covering the first conductor lines with an eighth insulating material (44),
(n') producing the lithography mask (50) in the form of third strips (52),
(o') elimination of regions of the fifth, fourth, second and third materials which are not masked and in this way producing the stack of gates (54),
(p') elimination of the mask (50),
(q') filling the inter-stack spaces obtained in stage (o') with a ninth material (58), and
(r') producing second conductor lines (60a, 62a) on the stacks (54) oriented perpendicular to the first conductor lines.

13. Production process according to claim 12, characterized in that as the substrate (2) is made from silicon, the stage of producing the first conductor lines (42a, 42b) comprises the following stages:
- deposition on the structure obtained during stage (k') of a layer (40) of a metal able to form a silicide,
- thermal annealing of the assembly in order to react the metal directly in contact with the exposed substrate regions to locally form a silicide (42), and
- elimination of the regions of the metal which have not reacted with the substrate.

14. Production process according to claim 12, characterized in that the stage of producing the first conductor lines (66a, 68a) comprises the following stages:
- deposition on the structure obtained during stage (k') of a layer of at least one tenth conductive material (66, 68),
- deposition on the tenth material of a resin layer (70) cancelling out the relief of the tenth material,
- etching the resin layer so as to only retain the resin in the hollowed out parts of the relief of the tenth material (66, 68),
- etching the tenth material and elimination of the resin (70).

15. Production process according to any one of the claims 10 to 14, characterized in that the first, third, fourth, sixth and/or seventh materials are of silicon dioxide (SiO₂).

16. Production process according to any one of the claims 10 to 15, characterized in that the second and/or fifth materials are of phosphorus-doped polycrystalline silicon.

## Patentansprüche

1. Nichtflüchtige, auf ein Halbleitersubstrat (2) integrierte Speicherzelle, umfassend
(a) eine Matrix von Speicherpunkten (53), die elektrisch und seitlich voneinander isoliert sind, wobei jeder Speicherpunkt (53) einen Gate-Stapel (54), der gebildet wird von einem ersten Isolator (12a) in Kontakt mit dem Substrat (2), einem floatenden (16a) und einem Steuergate (22a), die voneinander durch einen zweiten Isolator (20a) getrennt sind, wobei das floatende Gate eine Fläche in Kontakt mit dem ersten Isolator besitzt, sowie eine Source (32) und ein Drain (19, 34), die im Substrat (2) auf der einen und der anderen Seite des Gate-Stapels (54) ausgebildet sind, und einen unter genanntem Stapel gelegenen Kanal umfaßt, dessen Länge nach einer ersten Richtung (x) orientiert ist, die von der Source zum Drain geht, und
(b) Leiterbahnen (60a, 62a, 42a, 66a, 68a), die dazu dienen, Signale an die Gate-Stapel (54) und an die Drains zu legen,
dadurch gekennzeichnet, daß der zweite Isolator (20a) in einer zur Oberfläche des Substrats senkrechten und die erste Richtung (x) enthaltenden Ebene die Gestalt eines umgekehrten U besitzt, in dessen Innerem das gesamte floatende Gate untergebracht ist,
und dadurch, daß das Steuergate (22a) ebenfalls die Gestalt eines umgekehrten U besitzt, das keine Verlängerung nach der ersten Richtung (x) aufweist, in dessen Innerem sich der gesamte zweite Isolator (20a) befindet, wobei das Steuergate die seitlichen Isolationen (58) sowohl in der ersten Richtung (x) als auch in einer zweiten, auf der ersten senkrechten Richtung (y) nicht überragt.

2. Speicherzelle nach Anspruch 1, dadurch gekennzeichnet, daß das floatende Gate (16a) eine Höhe besitzt, die mindestens zweimal größer ist als seine Breite.

3. Speicherzelle nach Anspruch 1 oder 2, dadurch gekennzeichnet, daß die Breite des floatenden Gates (16a) kleiner als 0,5 µm ist.

4. Speicherzelle nach einem der Ansprüche 1 bis 3, dadurch gekennzeichnet, daß der erste Isolator (12a) eine kleinere Dicke als der zweite Isolator (20a) hat.

5. Speicherzelle nach einem der Ansprüche 1 bis 4, dadurch gekennzeichnet, daß die Leiterbahnen (60a, 62a), die dazu dienen, die Gate-Stapel (54) zu steuern, aus zu der ersten Richtung parallelen Streifen bestehen, und dadurch, daß die Leiterbahnen (42a, 66a, 68a), die dazu dienen, die Drains (19, 34) zu steuern, senkrecht zu der ersten Richtung sind.

6. Speicherzelle nach einem der Ansprüche 1 bis 5, dadurch gekennzeichnet, daß die Leitungen (42a, 66a, 68a) zur Steuerung der Drains (19, 34) als metallische Schicht oder als Silicidschicht ausgeführt sind.

7. Speicherzelle nach Anspruch 6, dadurch gekennzeichnet, daß eine Schicht (66a) aus Metall auf dem Halbleitersubstrat (2) vorgesehen ist, die als Diffusionsbarriere für die Leitungen (68a) zur Steuerung der Drains dient.

8. Speicherzelle nach einem der Ansprüche 1 bis 6, dadurch gekennzeichnet, daß die Leiterbahnen (60a, 62a), die dazu dienen, die Gate-Stapel (54) zu steuern, in Metall ausgeführt sind.

9. Speicherzelle nach einem der Ansprüche 1 bis 8, dadurch gekennzeichnet, daß das Steuergate (22a) teilweise das Drain (19, 34) und damit den genannten Kanal und nicht die Source (32) überdeckt.

10. Verfahren zur Herstellung einer nichtflüchtigen, auf ein Halbleitersubstrat (2) integrierten Speicherzelle, die
(a) eine Matrix von Speicherpunkten (53), die voneinander durch seitliche Isolationen (38, 44, 58) elektrisch isoliert sind, wobei jeder Speicherpunkt (53) ein floatendes Gate (16a) und ein Steuergate (22a), die übereinandergeschichtet und voneinander isoliert sind, eine Source (32) und ein Drain (19, 34), die auf der einen und auf der anderen Seite des Gate-Stapels (54) liegen, und einen unter genanntem Stapel gelegenen Kanal umfaßt, der mit seiner Länge nach einer ersten Richtung (x) orientiert ist, die von der Source zum Drain geht, und
(b) Leiterbahnen (60a, 62a, 42a, 66a, 68a) umfaßt, die dazu dienen, elektrische Signale an die Gate-Stapel (54) und an die Drains (34) der Speicherpunkte anzulegen,
dadurch gekennzeichnet, daß die floatenden Gates (16a) erzeugt werden, indem man in isotroper Weise auf Stufen (10) aus einem ersten Material eine Schicht (14) eines zweiten, leitenden Materials, das selektiv gegenüber dem ersten Material geätzt werden kann, abscheidet, die Schicht des zweiten Materials in anisotroper Weise bis zur Freilegung der Stufen ätzt, die Drains der Speicherzellen bildet und die Stufen des ersten Materials entfernt,
und dadurch, daß man anschließend die von den floatenden Gates isolierten Steuergates, die Sources der Speicherpunkte und dann die Leiterbahnen erzeugt.

11. Verfahren zur Herstellung nach Anspruch 10, dadurch gekennzeichnet, daß man die Gate-Stapel bildet, indem man nacheinander die folgenden Schritte ausführt:
(a) Herstellen von Stufen (10) aus erstem Material auf einem Halbleitersubstrat (2) eines ersten Leitungstyps, wobei diese Stufen die Gestalt erster Streifen haben, die senkrecht zur ersten Richtung (x) orientiert sind,
(b) Abscheiden eines dritten isolierenden Materials (12) auf dem Substrat zwischen den Stufen,
(c) isotrope Abscheidung der Schicht (14) des zweiten Materials auf den Stufen und dem dritten Material,
(d) anisotropes Ätzen der Schicht des zweiten Materials, um parallel zu den ersten Streifen zweite leitende Streifen (16) zu erhalten,
(e) Entfernen der Stufen (10) und der nicht vom zweiten Material bedeckten Bereiche des dritten Materials,
(f) Abscheiden eines vierten, isolierenden Materials (18, 20) auf den in Schritt (e) freigelegten Bereichen des Substrats und auf den zweiten leitenden Streifen,
(g) Abscheiden eines fünften, leitenden Materials (22) auf dem vierten Material, das Bereiche (28) zeigt, die die zweiten leitenden Streifen überragen,
(h) Maskieren (30) der überragenden Bereiche des fünften Materials mit Hilfe eines sechsten Materials,
(i) Entfernen der von dem sechsten Material nicht überdeckten Bereiche des fünften und des vierten Materials,
(j) Erzeugung einer Lithographiemaske (50), die die Gestalt von dritten Streifen (52) besitzt, die senkrecht zu den zweiten Streifen orientiert sind und die die Länge der Stapel (54) festlegen,
(k) Entfernen der nicht maskierten Bereiche des fünften, vierten, zweiten und dritten Materials, um so die Gate-Stapel (54) zu erzeugen, und
(l) Entfernen der Maske (50).

12. Herstellungsverfahren nach Anspruch 10 oder 11, dadurch gekennzeichnet, daß es nacheinander die folgenden Schritte umfaßt:
(a') Erzeugen von Stufen (10) aus erstem Material auf dem Halbleitersubstrat,
(b') Anscheiden des dritten, isolierenden Materials (12) auf dem Substrat zwischen den Stufen (10),
(c') isotrope Abscheidung der Schicht des zweiten Materials (14) auf den Stufen und dem dritten Material,
(d') anisotropes Ätzen der Schicht des zweiten Materials, um die zweiten leitenden Streifen (16) zu erhalten, dann Implantieren von Ionen eines zweiten Leitungstyps zwischen den zweiten Streifen, um teilweise die Drains (19) zu bilden,
(e') Entfernen der Stufen (10) und der vom zweiten Material nicht bedeckten Bereiche des dritten Materials,
(f') Anscheiden des vierten Materials (18, 20),
(g') Anscheiden des fünften, leitenden Materials (22) auf dem vierten Material,
(h') Maskieren (30) der überragenden Teile (28) des fünften Materials mit Hilfe des sechsten Materials,
(i') Entfernen der von dem sechsten Material nicht überdeckten Bereiche des fünften Materials,
(j') Implantieren von Ionen eines zweiten Leitfähigkeitstyps in die an die überstehenden Teile angrenzenden Substratbereiche, um die Sources (32) und die Drains (34) zu bilden,
(k') Erzeugen von Abstandselementen (38) aus einem siebten, isolierenden Material auf den Seitenwänden der überragenden Teile des fünften Materials und Entfernen der durch das sechste Material nicht überdeckten Bereiche des vierten Materials (18),
(l') Erzeugen von ersten Leiterbahnen (42a, 42b, 66a, 68a) auf den Sources und den Drains, die parallel zu den zweiten leitenden Streifen orientiert sind,
(m') Überdecken der ersten Leiterbahnen mit einem achten, isolierenden Material (44),
(n') Erzeugen der Lithographiemaske (50), die die Form von dritten Streifen (52) besitzt,
(o') Entfernen der nicht maskierten Bereiche des fünften, vierten, zweiten und dritten Materials, um so die Gate-Stapel (54) zu erzeugen,
(p') Entfernen der Maske (50),
(q') Auffüllen der im Schritt (o') zwischen den Stapeln erhaltenen Zwischenräume mit einem neunten Material (58), und
(r') Erzeugen von zweiten Leiterbahnen (60a, 62a) auf den Stapeln (54), die senkrecht zu den ersten Leiterbahnen orientiert sind.

13. Herstellungsverfahren nach Anspruch 12, dadurch gekennzeichnet, daß, wenn das Substrat (2) in Silicium ausgeführt wird, der Schritt der Herstellung der ersten Leiterbahnen (42a, 42b) die folgenden Schritte umfaßt:
- Abscheiden einer Schicht (40) eines Metalls, das zur Bildung eines Silicids fähig ist, auf der in Schritt (k') erhaltenen Struktur,
- Behandlung der Anordnung durch thermisches Anlassen, um das Metall, das direkt in Kontakt mit den freigelegten Substratbereichen ist, reagieren zu lassen, um lokal ein Silicid (42) zu bilden, und
- Entfernen der Bereiche des Metalls, die nicht mit dem Substrat reagiert haben.

14. Herstellungsverfahren nach Anspruch 12, dadurch gekennzeichnet, daß der Schritt der Erzeugung der ersten Leiterbahnen (66a, 68a) die folgenden Schritte umfaßt:
- Abscheiden einer Schicht wenigstens eines zehnten, leitenden Materials (66, 68) auf der in Schritt (k') erhaltenen Struktur,
- Abscheiden einer Lackschicht (70) auf dem Zehnten Material, die das Profil des zehnten Materials einebnet,
- Ätzen der Lackschicht, um Lack nur an den hohlen Stellen des Profils des zehnten Materials (66, 68) zu bewahren,
- Ätzen des zehnten Materials und Entfernung des Lackes (70).

15. Herstellungsverfahren nach einem der Ansprüche 10 bis 14, dadurch gekennzeichnet, daß das erste, dritte, vierte, sechste und/oder das siebte Material aus Siliciumdioxid (SiO₂) bestehen.

16. Herstellungsverfahren nach einem der Ansprüche 10 bis 15, dadurch gekennzeichnet, daß das zweite und/oder das fünfte Material aus polykristallinem, mit Phosphor dotiertem Silicium bestehen.
